# EUROPEAN PATENT APPLICATION

(11) **EP 4 650 807 A1**
(43) Date of publication of application: **19.11.2025**
(21) Application number: 24175777.2
(22) Date of filing: 14.05.2024
(51) Int. Cl.: G01R 33/3815, G01R 33/34, H01R 4/68, H01F 6/06, H10N 60/01

(54) **MAGNETIC RESONANCE IMAGING MAGNET ASSEMBLY WITH SOLDER JOINT**

(71) Applicant: Koninklijke Philips N.V., 5656 AG Eindhoven (NL)
(72) Inventor: FORTHMANN, Peter, Eindhoven (NL)
(74) Representative: Philips Intellectual Property & Standards

(57) **Abstract**

The invention discloses a method of manufacturing a magnet assembly (1), comprising: providing two wires (2) each comprising a superconducting material; embracing the two wires (2) with a brace (3); sliding a sleeve (4) over the brace (3); filling a soldering material (5) into the interior of the brace (3); heating up the soldering material (5) to its soldering temperature; and letting the soldering material (5) cool down for hardening. In this way, an easy to apply possibility for producing good solder joints in a convenient and repeatable fashion even for brittle conductors is provided.

## Description

### FIELD OF THE INVENTION

The invention relates to the field of magnetic resonance (MR) examination, and especially to an MR imaging magnet assembly.

### BACKGROUND OF THE INVENTION

Superconducting magnets are essential in various applications, notably in medical imaging devices like magnetic resonance imaging (MRI) systems, where they are used for generating the strong and stable magnetic fields necessary for high-resolution imaging.

MRI systems use superconducting magnets because they can create extremely strong magnetic fields without generating heat from electrical resistance, which would be prohibitive with conventional conductors. These magnets are typically made from coils of superconducting wire, cooled to very low temperatures where they exhibit superconductivity, i.e. zero electrical resistance.

The superconducting wire used in these coils may be made from materials like niobium-titanium or magnesium diboride. The field of superconducting magnets, particularly magnesium diboride (MgB₂) high-temperature superconducting (HTS) magnets, has been of high interest in recent years. To create the necessary magnetic field strength, these coils must be made from long lengths of wire, often exceeding the maximum available continuous length of superconducting wire. This discrepancy necessitates the use of joints to connect segments of wire, ensuring the coil functions as a single, continuous loop.

The challenge arises in how to join these segments of superconducting wire, in particular for wires made from brittle materials like magnesium diboride.

Making low-resistance, reliable, and repeatable joints in the context of superconducting coils is fraught with difficulties. Any resistance in the joints disrupts the superconductivity, diminishing the efficiency of the magnet and potentially introducing heat, which is highly undesirable in superconducting applications. The joints must be durable and reliable over time, as any failure could compromise the MRI machine's functionality, requiring costly repairs and maintenance. In manufacturing and maintenance, the ability to consistently create high-quality joints is crucial for the standardized performance of MRI apparatuses. The brittle nature of materials like magnesium diboride complicates the joining process. Brittle materials can crack or break under mechanical stress, making the process of joining them without damaging them more complex.

US 4,744,506 describes that the ends of a plurality of copper conductors bearing superconductive strands, for example of niobium titanium, are treated with a liquid metal solvent to selectively remove the copper from the superconductive strands. The liberated strands of superconductor are then soldered with a superconducting solder. The joint is included in a coil which at superconducting temperatures induces a high magnetic field of 0.5 Tesla and above.

### SUMMARY OF THE INVENTION

It is the object of the invention to provide an easy to apply possibility for producing good solder joints in a convenient and repeatable fashion for brittle conductors.

According to the invention, this object is addressed by the subject matter of the independent claims. Preferred embodiments of the invention are described in the dependent claims.

Therefore, according to the invention, a magnetic resonance imaging magnet assembly is provided, comprising:
two wires each comprising a superconducting material,
a brace which embraces the two wires,
a sleeve that is slid over the brace, and
a hardened soldering material which is arranged at least in an area between the brace and the wires.

This approach relates to the manufacturing of a magnetic resonance imaging magnet assembly, especially utilizing brittle superconducting materials to achieve high magnetic fields necessary for MRI applications at higher temperatures as with conventional superconductor materials. This assembly focuses on enhancing the electrical and mechanical integrity of the magnet by detailing a specific configuration involving superconducting wires, a brace, a sleeve, and a soldering material. The superconducting wires are preferably made from HTS materials like magnesium diboride which may be very brittle. The brace embraces or holds together the two superconducting wires. It provides mechanical stability, ensuring that the wires are maintained in close contact to each other, which is critical for the performance of the magnet. The sleeve is configured for sliding over the brace and the embraced wires and, in this way, serves multiple purposes, including additional mechanical support and protection for the wires and brace. The soldering material is applied in the area between the brace and the wires, and after hardening it ensures a strong mechanical bond and excellent electrical contact between the brace and the wires. This is crucial for minimizing electrical resistance at the joints, which could otherwise lead to heating and loss of superconductivity.

In driven mode, where there is a power supply driving the circuit continuously, low resistance is critical for not creating hot spots. Higher resistance means more dissipated energy in a joint, and a temperature rise adversely affects the current carrying ability since a superconductor can carry less current the warmer it becomes. The losses themselves are not a problem in driven mode, because the power supply will provide the dissipation energy.

Another powering method is persistent mode, where the circuit is charged with current once, which is left to circulate after that. Here, there are the same problems as mentioned above, and an additional one that is related to real persistence, which can only be achieved with superconducting joints. Then, the current can flow basically indefinitely. With lossy joints, however, the current will decay after charging, and the decay rate is higher with higher joint resistance. Therefore, if persistent operation is desired, low-resistance joints are crucial.

While, in general, it is possible to fill only part of the interior of the brace with the soldering material, according to an embodiment of the invention, the interior of the brace and the sleeve are completely filled with the soldering material. This makes the joint even more resistant and reliable.

For easily filling in the soldering material, according to an embodiment of the invention, the brace and the sleeve each comprise a side wall with an opening, the openings being aligned to each other.

It is possible to design the brace in such a way that it can be slid over the wires without any effort. However, according to an embodiment of the invention, the wires are compressed by the brace, which means that the brace has to be spread for sliding it over the wires. In addition, it might be preferred that the brace is compressed by the sleeve due to different thermal expansion coefficients of the brace and the sleeve, respectively.

While, in general, the brace and the sleeve may be made from any suitable material and even from the same type of material, according to an embodiment of the invention, the brace is made from a material that has higher thermal expansion coefficient than the material of the sleeve, e.g., the brace is made from copper and the sleeve is made from steel. Since copper has a higher expansion coefficient than steel, the heat will add additional pressure to the wires, which will result in an even lower resistance. In this respect, the brace may also be made from brass, and the sleeve may also be made from a ceramic material. In addition, it is advantageous if the brace comprises a wall with multiple direction changes, even in section in which straight running walls would be possible, in order to achieve a greater circumferential length, so that when heated, the absolute expansion length is high, which results in a high squeezing effect.

Further, according to an embodiment of the invention, the two wires are inserted into the brace with their respective ends from two directions which are opposite to each other. In this way, one wire may act as an extension of the other wire.

In general, it is possible to provide the sleeve with the brace and the wires in different locations. However, according to an embodiment of the invention, the assembly comprises a coil flange for supporting a coil of the magnetic resonance imaging magnet assembly, and the sleeve with the brace and the wires is embedded in a recess in the coil flange.

The invention also relates to a magnetic resonance imaging system with a magnetic resonance imaging magnet assembly as described above.

The invention further relates to a method for manufacturing a magnetic resonance imaging magnet assembly, comprising the following method steps:
providing two wires each comprising a superconducting material,
embracing the two wires with a brace,
sliding a sleeve over the brace,
filling in a soldering material into the interior of the sleeve and the brace,
heating up the soldering material to its solder temperature, and
letting the soldering material cool down for hardening.

Heating up the soldering material may be achieved by different methods. However, preferably heating up the soldering material to its solder temperature is achieved by applying a current along a part of the sleeve.

According to an embodiment of the invention, when the sleeve is slid over the brace, the brace is elastically deformed and pressed against the wires. In this respect, when the brace is elastically deformed and pressed against the wires, according to an embodiment of the invention, the wires are pressed together.

According to another embodiment of the invention, the soldering material is a liquid soldering paste which becomes solid after heating up to its soldering temperature and cooling down again. When cooling down, the soldering material becomes at least solid at 300 K or a temperature higher than that, e.g., 500 K.

Further, it is preferred that the soldering material is filled into the interior of the sleeve and the brace through openings which are provided in the side walls of the sleeve and the brace, respectively, and which are aligned to each other. According to an embodiment of the invention, a current is applied to a part of the sleeve for heating up the soldering material to its solder temperature by arranging two electrodes on two opposite sides of the sleeve and applying a voltage between the two electrodes.

The invention also relates to a magnetic resonance imaging system with a magnet assembly as described above and a method of use of a magnet assembly according as described above for a magnetic resonance imaging system.

### BRIEF DESCRIPTION OF THE DRAWINGS

These and other aspects of the invention will be apparent from and elucidated with reference to the embodiments described hereinafter. Such an embodiment does not necessarily represent the full scope of the invention.

In the drawings:
Fig. 1a schematically depicts a copper brace according to an embodiment of the invention in a perspective view;
Fig. 1b schematically depicts the brace of Fig. 1a embracing two wires in a perspective view;
Fig. 1c schematically depicts the arrangement of Fig. 1b in a cross-sectional view;
Fig. 2a schematically depicts a steel sleeve according to an embodiment of the invention in a perspective view;
Fig. 2b schematically depicts the sleeve of Fig. 2a which is slid over the arrangement of Fig. 1b in a perspective view;
Fig. 2c schematically depicts the arrangement of Fig. 2b in a cross-sectional view;
Fig. 3 schematically depicts a magnetic resonance imaging magnet assembly according to an embodiment of the invention in a perspective cross-sectional view;
Fig. 4 schematically depicts the soldering process according to an embodiment of the invention;
Fig. 5 schematically depicts a magnetic resonance imaging system with a magnetic resonance imaging magnet assembly according to an embodiment of the invention.

### DETAILED DESCRIPTION OF EMBODIMENTS

For the purpose of promoting and understanding the principles of the present disclosure, reference will now be made to the embodiments illustrated in the drawings, and specific language will be used to describe the same. It is nevertheless understood that no limitation to the scope of the disclosure is intended. Any alteration and further modifications to the described devices, systems, and methods, and any further application of the principles of the present disclosure are fully contemplated and included within the present disclosure as would normally occur to one skilled in the art to which the disclosure relates. In particular, it is fully contemplated that the features, components, and/or steps described with respect to one embodiment may be combined with the features, components, and/or steps described with respect to other embodiments of the present disclosure. For the sake of brevity, however, the numerous iterations of these combinations will not be described separately. Features described in relation to a system, may be implemented in a method, in a corresponding manner.

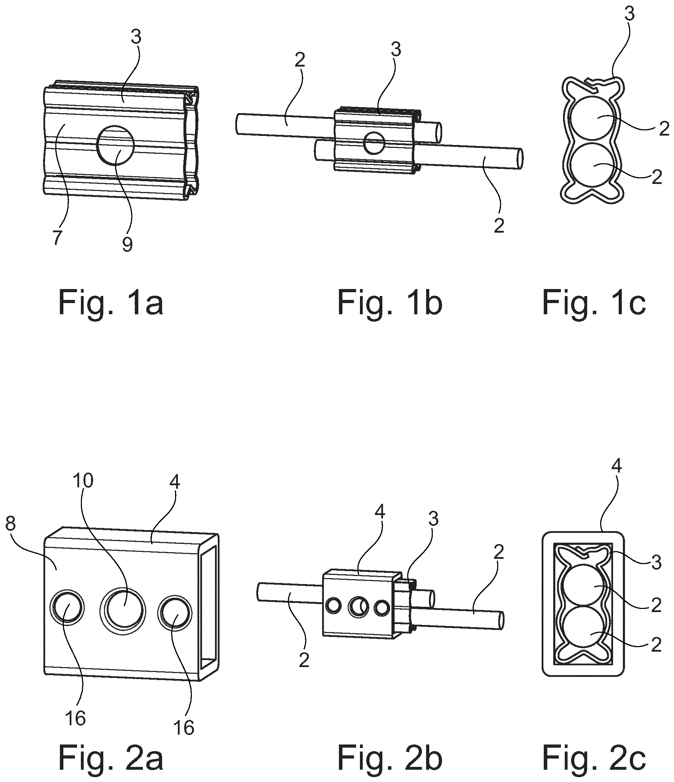

Fig. 1a schematically depicts a copper brace 3 according to an embodiment of the invention in a perspective view. As schematically shown in Figs. 1b and 1c, the brace 3 embraces two wires 2, with other words surrounds the two wires, which are fed into the brace 3, each with one of their respective ends. In this embodiment, the two wires 2 are inserted into the brace 3 with their respective ends from two directions which are opposite to each other.

The interior of the brace 3 has a smaller diameter than the wires 2, with other words the space enclosed by the brace is smaller than the diameters of the two wires, which means that the brace 3 has to be spread for feeding the wires 2 into the brace. As a result, the wires 2 are compressed by the brace 3.

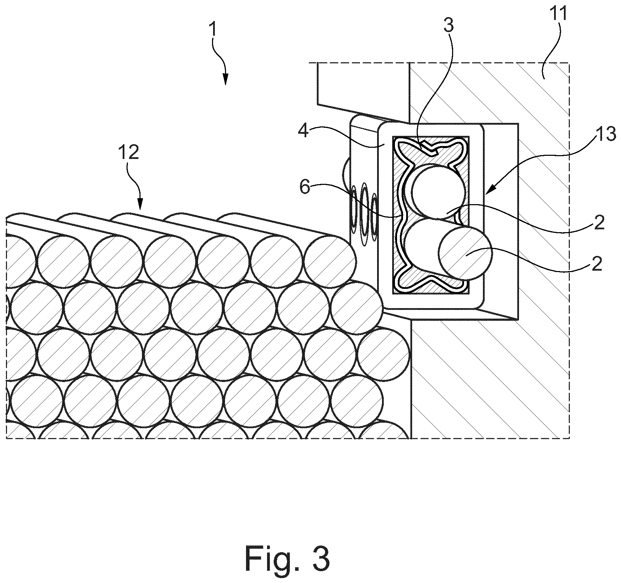

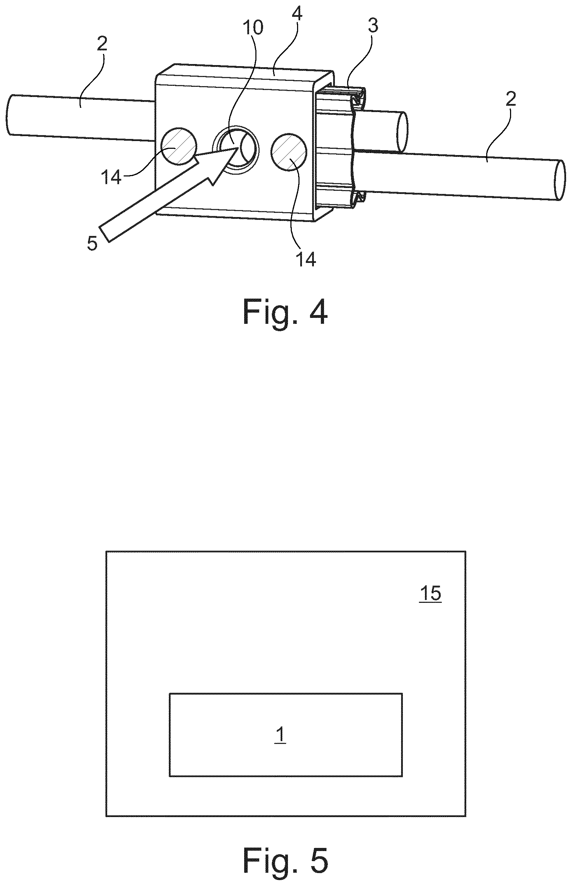

The two wires 2 each comprise magnesium diboride as a superconducting material for forming a coil 12 of the magnet assembly 1 for a magnetic resonance imaging system 15, as schematically depicted in Figs. 3 and 5.

As schematically illustrated in Fig. 2a, a steel sleeve 4 is provided, which is slid over the brace 3, as schematically shown in Fig. 2b and Fig. 2c. The brace 3 and the sleeve 4 each comprise a side wall 7, 8 with an opening 9, 10, wherein the openings 9, 10 are aligned to each other.

The arrangement of the copper brace 3, the steel sleeve 4 and the two wires 2 is then fixedly attached together by a soldering material, which is inserted into the interior of the brace 3 and the sleeve 4 as a soldering paste 5, schematically depicted in Fig. 4. The interior of the brace 3 and the sleeve 4 are filled with the soldering paste 5. As a soldering paste 5, in general, any soldering paste may be used. However, a soldering paste 5 with a high silver content is preferred due to its high conductivity.

Then, the soldering process is performed by applying a current along a part of the sleeve 4 and the brace for heating up the soldering paste 5 to its solder temperature, or with other words above its melting temperature. For this soldering process, electrodes 14 are attached to recesses 16 for these electrodes 14 in the side wall 8 of the sleeve 4. In the soldering process, after heating up the soldering paste 5 to its solder temperature, it is allowed to cool down again for hardening. The degree of filling with soldering paste may be as completely as possible, thought at least to a degree stretching between the two electrodes 14.

After hardening, the brace 3 is compressed by the hardened soldering material 6. The compression is due to the expansion of the brace 3 in the sleeve 4 that does not expand as much as the brace 3. The hardened soldering material 6 freezes the expansion state. Further, since the copper of the brace 3 has a higher expansion coefficient than the steel of the sleeve 4, the heat will add additional pressure to the wires 2, which will result in a lower electrical resistance between the wires 2.

As schematically depicted in Fig. 3, the magnet assembly comprises a coil flange 11 for supporting a coil 12 of the magnetic resonance imaging magnet assembly 1, and the sleeve 4 with the brace 3 and the wires 2 are embedded in a recess 13 in the coil flange 11. This allows for an easy and secure arrangement of the joint of the two wires 2 in the magnetic resonance imaging magnet assembly.

To summarize, a method for manufacturing a magnetic resonance imaging magnet assembly 1 according to an embodiment of the invention comprises the following method steps:
providing two wires 2 each comprising a superconducting material,
embracing the two wires 2 with a brace 3,
sliding a sleeve 4 over the brace 3, wherein when the sleeve 4 is slid over the brace 3, the brace 3 is elastically deformed and pressed against the wires 2 and the wires 2 are pressed together, and
filling in a soldering material 5 into the interior of the sleeve 4 and the brace 3,
wherein the soldering material 5 is a liquid soldering paste 5, which becomes solid after heating up to its soldering temperature and cooling down again,
wherein the soldering material 5 is filled into the interior of the sleeve 4 and the brace 3 through openings 9,10 which are provided in the side walls 7,8 of the sleeve 4 and the brace 3, respectively, and which are aligned to each other, and
wherein the current is applied to a part of the sleeve 4 for heating up the soldering material 5 to its solder temperature by arranging two electrodes 14 on two sides, e.g., opposite sides, of the sleeve 4 and applying a voltage between the two electrodes 14.

In this way, a method for making low-resistance solder joints is provided that is especially suited for intra-coil joints with brittle wire like magnesium diboride high-temperature superconductor. The method is convenient, as setting up is straightforward, and the soldering process is fast and requires no soldering iron. In addition, the wires 2 do not experience bending forces, and the bimetal action (copper/steel) causes additional clamping force during the soldering process, which helps reducing the resistance between the wires 2.

The superconducting magnet coils in any of the embodiments may be formed with coils comprising HTS material, such as any of MgB₂, rare-earth barium copper oxide (ReBCO), bismuth strontium calcium copper oxide (BSCCO). Examples of magnetic resonance imaging systems with superconducting magnet comprising HTS material are for example presented in the European patent application 23197904 filed on September 18, 2023, and European patent application 24159684 filed on February 26, 2024, which are incorporated by reference herein in their entirety. The additional benefit of MRI systems with superconducting magnet coils comprising HTS material is that such construction facilitates MR magnets to be quickly rampable (up or down). Such magnets can in principle be easily switched off when not in use, in order to minimize risks associated with the strong magnetic field.

Alternatively or additionally, some or all of the superconducting magnet coils may be made from regularly used materials, such as niobium and titanium alloys (NbTi) or niobium and tin alloys (Nb₃Sn), because the invention is also applicable for forming magnet assembly from coils comprising any of these regularly used materials.

It shall further be understood that one or more of the aforementioned embodiments of the invention may be combined as long as the combined embodiments are not mutually exclusive.

While the invention has been illustrated and described in detail in the drawings and foregoing description, such illustration and description are to be considered illustrative or exemplary and not restrictive; the invention is not limited to the disclosed embodiments. Other variations to the disclosed embodiments can be understood and effected by those skilled in the art in practicing the claimed invention, from a study of the drawings, the disclosure, and the appended claims. In the claims, the word "comprising" does not exclude other elements or steps, and the indefinite article "a" or "an" does not exclude a plurality. The mere fact that certain measures are recited in mutually different dependent claims does not indicate that a combination of these measures cannot be used to advantage. Any reference signs in the claims should not be construed as limiting the scope. Further, for the sake of clearness, not all elements in the drawings may have been supplied with reference signs.

## Claims

1. A magnet assembly (1), comprising:
two wires (2) each comprising a superconducting material;
a brace (3) embracing the two wires (2);
a sleeve (4) surrounding the brace (3); and
a hardened soldering material (6) arranged at least in an area between the brace (3) and the wires (2).

2. The magnet assembly (1) according to claim 1, wherein the interior of the brace (3) and the sleeve (4) are filled with the soldering material (6).

3. The magnet assembly (1) according to claim 1 or 2, wherein the brace (3) and the sleeve (4) each comprise a side wall (7, 8) with an opening (9, 10), the openings (9, 10) being aligned to each other.

4. The magnet assembly (1) according to any one of the preceding claims, wherein the wires (2) are compressed by the brace (3).

5. The magnet assembly (1) according to claim 4, wherein the brace (3) is compressed by the sleeve (4).

6. The magnet assembly (1) according to any one of the preceding claims, wherein the brace (3) is made from copper and/or brass and/or the sleeve (4) is made from steel and/or a ceramic material.

7. The magnet assembly (1) according to any one of the preceding claims, wherein the two wires (2) have their respective ends in the brace (3) pointing to opposite directions.

8. The magnet assembly (1) according to any one of the preceding claims, further comprising a coil flange (11) for supporting a coil (12) of the magnet assembly (1), wherein the sleeve (4) with the brace (3) and the wires (2) is supported in a recess (13) of the coil flange (11).

9. A method of manufacturing a magnet assembly (1), comprising:
providing two wires (2) each comprising a superconducting material;
embracing the two wires (2) with a brace (3);
sliding a sleeve (4) over the brace (3);
filling a soldering material (5) into the interior of the brace (3);
heating up the soldering material (5) to its soldering temperature; and
letting the soldering material (5) cool down for hardening.

10. The method according to claim 9, wherein when the sleeve (4) is slid over the brace (3), the brace (3) is elastically deformed and pressed against the wires (2).

11. The method according to claim 10, wherein when the brace (3) is elastically deformed and pressed against the wires (2), the wires (2) are pressed together.

12. The method according to any one of claims 9 to 11, wherein the soldering material (5) is a liquid soldering paste (5), which becomes solid after heating up to its soldering temperature and cooling down again.

13. The method according to any one of claims 9 to 12, wherein the soldering material (5) is filled into the interior of the sleeve (4) and the brace (3) through openings (10, 9) that are provided in the side walls (8, 7) of the sleeve (4) and the brace (3), respectively, and which are aligned to each other.

14. The method according to any one of claims 9 to 12, wherein a current is applied to a part of the sleeve (4) for heating up the soldering material (5) to its soldering temperature by arranging two electrodes (14) on two locations of the sleeve (4) and applying a voltage between the two electrodes (14).

15. A magnetic resonance imaging system (15) comprising a magnet assembly (1) according to any one of claims 1 to 8.
